(19) **Europäisches Patentamt**
European Patent Office
Office européen des brevets

(11) **EP 2 396 359 B1**

(12) **EUROPÄISCHE PATENTSCHRIFT**

(45) Veröffentlichungstag und Bekanntmachung des Hinweises auf die Patenterteilung:
**27.09.2017 Patentblatt 2017/39**

(21) Anmeldenummer: **10702444.0**

(22) Anmeldetag: **02.02.2010**

(51) Int Cl.:
**C08G 18/48** *(2006.01)* **C08G 18/78** *(2006.01)*
**C08G 18/77** *(2006.01)* **C08G 18/67** *(2006.01)*
**C08G 18/10** *(2006.01)* *G03F 7/027* *(2006.01)*
*G03H 1/02* *(2006.01)* *G11B 7/253* *(2013.01)*
*G03F 7/00* *(2006.01)* *G03F 7/035* *(2006.01)*
*G11B 7/245* *(2006.01)*

(86) Internationale Anmeldenummer:
**PCT/EP2010/000618**

(87) Internationale Veröffentlichungsnummer:
**WO 2010/091807 (19.08.2010 Gazette 2010/33)**

(54) **PHOTOPOLYMERZUSAMMENSETZUNGEN ALS VERDRUCKBARE FORMULIERUNGEN**

PHOTOPOLYMER COMPOUNDS AS COMPRESSIBLE FORMULATIONS

COMPOSITIONS PHOTOPOLYMÈRES EN TANT QUE FORMULES IMPRIMABLES

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **12.02.2009 EP 09001949**

(43) Veröffentlichungstag der Anmeldung:
**21.12.2011 Patentblatt 2011/51**

(73) Patentinhaber: **Covestro Deutschland AG**
**51373 Leverkusen (DE)**

(72) Erfinder:
• **RÖLLE, Thomas**
**51381 Leverkusen (DE)**
• **BRUDER, Friedrich-Karl**
**47802 Krefeld (DE)**
• **FÄCKE, Thomas**
**51375 Leverkusen (DE)**

• **WEISER, Marc-Stephan**
**51379 Leverkusen (DE)**
• **HÖNEL, Dennis**
**53909 Zülpich (DE)**
• **KÜNZEL, Roland**
**51381 Leverkusen (DE)**

(74) Vertreter: **Levpat**
**c/o Covestro AG**
**Gebäude 4825**
**51365 Leverkusen (DE)**

(56) Entgegenhaltungen:
**EP-A- 1 002 817 WO-A-03/014178**
**WO-A-03/023520 WO-A-2008/125199**

Bemerkungen:
Die Akte enthält technische Angaben, die nach dem Eingang der Anmeldung eingereicht wurden und die nicht in dieser Patentschrift enthalten sind.

## Beschreibung

Die Erfindung betrifft die Applikation neuartiger Photopolymere auf Basis spezieller Urethanacrylate als Schreibmonomere, die sich für die Herstellung holographischer Medien, insbesondere zur visuellen Darstellung von Bildern eignen, in Druckverfahren.

Photopolymere stellen Materialien dar, die mittels der Überlagerung zweier kohärenter Lichtquellen belichtet werden können, wobei sich eine dreidimensionale Struktur in den Photopolymeren ausbildet, die sich im allgemeinen durch eine regionale Änderung des Brechungsindexes in dem Material beschreiben lässt. Derartige Strukturen werden Hologramme genannt. Sie können auch als diffraktive optische Elemente beschrieben werden. Dabei hängt es von der speziellen Belichtung ab, welche optischen Funktionen ein solches Hologramm ausbildet.

Für die Anwendung von Photopolymeren als Träger von Hologrammen für optische Anwendungen im sichtbaren Bereich werden in der Regel nach der Belichtung farblose oder lediglich sehr schwach gefärbte Materialien mit einer hohen Beugungswirkung gefordert. Seit den Anfängen der Holographie werden Silberhalogenidfilme insbesondere diejenigen mit hohem Auflösungsvermögen hierfür verwendet. Auch Dichromatgelatine (DCG), Dichromatsalz-haltige Gelatinefilme, oder auch Mischformen aus Silberhalogenid und DCG werden verwendet. Beide Materialien benötigen eine chemische Nachbehandlung zur Bildung eines Hologramms, was für industrielle Prozesse zusätzliche Kosten erzeugt und den Umgang mit chemischen Entwicklerlösungen erforderlich macht. Zudem haben nasschemische Verfahren ein Quellen und später ein Schrumpfen des Filmes zufolge, was zu Farbverschiebungen in den Hologrammen führen kann, was unerwünscht ist.

US 4959284 beschreibt Photopolymere, die u.a. aus einem in organischen Lösungsmitteln löslichen Thermoplasten wie Polyvinylacetat, Celluloseacetobutyrat oder Polymethylmethacrylat-Styrol-Copolymere, einem Photoinitiator und mindestens einem Vinylcyclopropanderivat bestehen. In EP352774A1 werden zudem andere Vinylgruppen haltigen Monomere beschrieben wie N-Vinylpyrrolidon, Phenoxyethylacrylat und Acrylester von Triolen wie Trimethylolpropan (TMPTA) und ethoxylierten Trimethylolpropan (TMPEOTA) oder andere Acrylester oder Acrylamide. Es ist in der Industrie bekannt, dass derartige Photopolymere erst nach einer längeren Temperaturbehandlung brauchbare Hologramme zeigen. O'Neill et al. (Applied Optics, Vol. 41, No.5, Seite 845ff., 2002) diskutieren in ihrem Übersichtsartikel neben den schon erwähnten Materialen auch noch Photopolymere, die aus Thermoplasten und Acrylamid erhältlich sind. Neben dem ungünstigen toxikologischen Profil von Acrylamid, zeigen derartige Produkte keine hellen Hologramme.

Auch bekannt sind holographisch aktive Materialien, in denen Farbstoffe eingeblendet werden, die unter Lichteinfluss ihren Photoempfindlichkeit verändern (Luo et al, Optics Express, Vol. 13, No.8, 2005, Seite 3123). Ähnlich beschreibt Bieringer (Springer Series in Optical Sciences (2000), 76, Seite 209-228.) sog. photoadressierbare Polymere, die ebenfalls polymergebundene Farbstoffe sind, die unter Lichteinfluss isomerisiert werden können. In beide Substanzklassen kann man Hologramme einbelichten und diese Materialien zur holographischen Datenspeicherung verwenden. Allerdings sind diese Produkte naturgemäß stark gefärbt und damit nicht für die oben beschriebenen Anwendungen geeignet.

In jüngerer Zeit wurden zudem Photopolymere beschrieben, die nicht aus Thermoplasten, sondern aus vernetzten Polymeren erhalten werden: So ist in US 020070077498 2,4,6-Tribromphenylacrylat beschrieben, das in einer Polyurethanmatrix gelöst ist. US 6103454 beschreibt ebenfalls eine Polyurethanmatrix mit polymerisierbaren Komponenten wie 4-Chlorphenylacrylat, 4-Bromstryrol und Vinylnapthalen. Diese Formulierungen wurden für die holographische Datenspeicherung entwickelt, eine holographischen Anwendung, in der man viele, aber auch sehr schwache, nur mit elektronischen Detektoren lesbare Hologramme einschreibt und ausliest. Für optische Anwendungen im gesamten sichtbaren Bereich sind derartige Formulierungen nicht geeignet.

Außerdem sind niedrigviskose Photopolymerformulierungen (DE102004030019, WO2005124456), in denen ein difunktionelles Acrylat mit einem Gemisch natürlicher ungesättigter Öle, einem Photoinitiator und einem Additiv enthalten ist, beschrieben.

WO 2008/125199 A offenbart aromatische Urethanacrylate die einen hohen Brechungsindex aufweisen.

WO03/014178 A offenbart ein Verfahren und einen Zusammensetzung zur schnellen Massenproduktion von Artikeln zur holographischen Aufnahme.

WO 03/023520 A offenbart ein holographisches Photopolymer-Datenaufzeichungsmedium, ein Verfahren zur Herstellung und ein Verfahren zum holographischen Auslesen, Aufnehmen und Speichern von Daten.

EP 1002817 A offenbart eine photohärtbare Zusammensetzung.

Aus der nicht vorveröffentlichten PCT/EP2008/002464, EP 08017279.4, EP 08017277.8, EP 08017273.7, EP 08017275.2 sind Formulierungen von Urethanacrylaten als Schreibmonomere in Polyurethanmatrizes bekannt. Davon ausgehend wurde nun gefunden, dass unter bestimmten Umständen ein Verdrucken solcher Photopolymerformulierungen möglich ist.

Die Erfindung ist durch die angefügten Ansprüche definiert.

Gegenstand der Erfindung sind daher Polyurethanzusammensetzungen geeignet zum Verdrucken, umfassend

A) eine Polyisocyanatkomponente, wenigstens enthaltend ein NCO-terminiertes Polyurethanprepolymer dessen NCO-Gruppen primär aliphatisch gebunden sind und welches auf hydroxyfunktionellen Verbindungen mit einer OH-Funktionalität von 1,6 bis 2,05 basiert,

B) Isocyanat-reaktive Polyetherpolyole

C) Urethanacrylate und/oder Urethanmethacrylate mit mindestens einer aromatischen Struktureinheit und einem Brechungsindex von größer 1.50 bei 405 nm, die selbst frei von NCO-Gruppen und OH-Gruppen sind

D) Radikalstabilisatoren

E) Photoinitiatoren auf Basis von Kombinationen aus Boratsalzen und einem oder mehreren Farbstoffen mit Absorptionsbanden, die zumindest teilweise den Spektralbereich von 400 bis 800 nm abdecken

F) gegebenenfalls Katalysatoren

G) Hilfs- und Zusatzstoffe,
wobei in A) als Prepolymere Urethane oder Allophanate aus aliphatischen Isocyanat-funktionellen Verbindungen und oligomeren oder polymeren Isocyanat-reaktiven Verbindungen eingesetzt werden, wobei die Prepolymere zahlenmittlere Molmassen von 200 bis 10000 g/Mol und NCO-Funktionalitäten von 1.9 bis 5.0 aufweisen.

Ebenfalls ein Gegenstand der Erfindung ist ein Verfahren zur Herstellung bedruckter Folien, bei dem solche erfindungsgemäßen Polyurethanzusammensetzungen in oder als Druckfarbe auf eine Folie appliziert werden.

Weiterer Gegenstand der Erfindung ist der Folienaufbau der bedruckten Folie.

Die erfindungswesentlichen Prepolymere der Komponente A) werden in dem Fachmann an sich gut bekannter Art und Weise durch Umsetzung von monomeren, oligomeren oder Polyisocyanaten A1) mit isocyanatreaktiven Verbindungen A2) in geeigneter Stöchiometrie unter optionalem Einsatz von Katalysatoren und Lösemitteln erhalten.

Auf diese Weise können NCO-funktionelle Prepolymere mit Urethan-, Allophanat-, Biuret- und/oder Amidgruppen hergestellt werden.

Als Polyisocyanate A1) zum Aufbau der Prepolymere werden aliphatische isocyanatfunktionelle Verbindungen eingesetzt.Auch offenbart ist, dass sich als Polyisocyanate A1) alle dem Fachmann an sich bekannten aliphatischen, cycloaliphatischen, aromatischen oder araliphatischen Di- und Triisocyanate eignen, wobei es unerheblich ist, ob diese mittels Phosgenierung oder nach phosgenfreien Verfahren erhalten wurden. Daneben können auch die diem Fachmann an sich gut bekannten höhermolekularen Folgeprodukte monomerer Di- und/oder Triisocyanate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur jeweils einzeln oder in beliebigen Mischungen untereinander eingesetzt werden.

Bevorzugte monomere Di- oder Triisocyanate, die als Komponente A1) eingesetzt werden können, sind Butylendiisocyanat, Hexamethylendiisocyanat (HDI), Isophorondiisocyanat (IPDI), Trimethyl-hexamethylen-diisocyanat (TMDI), und/oder Isocyanatomethyl-1,8-octandiisocyanat (TIN). Besonders bevorzugt sind TIN, TMDI und HDI und ganz besonders bevorzugt ist HDI.

Als isocyanatreaktive Verbindungen A2) zum Aufbau der Prepolymere werden OH-funktionelle Verbindungen mit einer OH-Funktionalität von bevorzugt 1.9 bis 2.01, besonders bevorzugt 2.0 eingesetzt.

Als isocyanatreaktive Verbindungen A2) zum Aufbau der Prepolymere werden oligomere oder polymere Isocyanat-reaktive Verbindungen eingesetzt.

Auch offenbart ist, dass sind oligomere oder polymere Isocyanat-reaktive Verbindungen des vorstehend genannten Funktionalitätsbereichs hierfür eignen wie niedermolekulare kurzkettige, d.h. 2 bis 20 Kohlenstoffatome enthaltende aliphatische, araliphatische oder cycloaliphatische Diole. Beispiele für solche Diole sind Ethylenglykol, Diethylenglykol, Triethylenglykol, Tetraethylenglykol, Dipropylenglykol, Tripropylenglykol, 1,2-Propandiol, 1,3-Propandiol, 1,4-Butandiol, Neopentylglykol, 2-Ethyl-2-butylpropandiol, Trimethylpentandiol, stellungsisomere Diethyloctandiole, 1,3-Butylenglykol, Cyclohexandiol, 1,4-Cyclohexandimethanol, 1,6-Hexandiol, 1,2- und 1,4-Cyclohexandiol, hydriertes Bisphenol A (2,2-Bis(4-hydroxycyclohexyl)propan), 2,2-Dimethyl-3-hydroxypropionsäure(2,2-dimethyl-3-hydroxypropylester).

Geeignet sind auch höhermolekulare aliphatische und cycloaliphatische Polyole des vorstehend genannten Funktionalitätsbereichs wie Polyesterpolyole, Polyetherpolyole, Polycarbonatpolyole, hydroxyfunktionelle Acrylharze, hydroxyfunktionelle Polyurethane, hydroxyfunktionelle Epoxyharze oder entsprechende Hybride.

Als solche Polyetherpolyole seien z. B. die difunktionellen Polyadditionsprodukte des Ethylenoxid, Propylenoxid, Tetrahydrofuran, Butylenoxid, sowie ihre Mischadditions- und Pfropfprodukte, sowie die durch Kondensation von zweiwertigen Alkoholen oder Mischungen derselben und die durch Alkoxylierung von zweiwertigen Alkoholen gewonnenen Polyetherpolyole genannt. Bevorzugte difunktionelle Polyetherpolyole sind Poly(propylenoxid)e, Poly(ethylenoxide) und deren Kombinationen in Form von statistischen oder Blockcopolymeren sowie Mischungen derselben mit einer zahlenmittleren Molmasse zwischen 600 und 8000 g/Mol und ganz besonders bevorzugt mit einer zahlenmittleren Molmasse zwischen 1000 und 4500 g/Mol.

Besonders bevorzugt werden als A2) Poly(propylenoxid)e des vorstehend genannten Funktionalitätsbereichs mit zahlenmittleren Molmassen zwischen 650 g/mol und 4500 g/mol, besonders bevorzugt mit zahlenmittleren Molmassen zwischen 1000 g/mol und 4100 g/mol und ganz besonders bevorzugt mit zahlenmittleren Molmassen zwischen 1900 g/mol und 2100 g/mol eingesetzt.

Beim Prepolymeraufbau wird zur Urethanisierung Isocyanat gemäß A1) mit Alkohol gemäß A2) in stöchiometrischen Mengen umgesetzt, wobei eine Urethangruppe entsteht. Als Alkohole eignen sich in diesem Falle für die Umsetzung mit den erwähnten Di-, Tri- und Polyisocyanaten alle oligomeren oder polymeren, sekundären, difunktionellen Alkohole der vorstehend genannten Art. Im Rahmen der Urethanprepolymere sind dies bevorzugt Tri-, Tetrapropylenglykol, Polyethylenglycol, Polypropylenglykol, Block- und/oder Copolymere aus Ethylenoxid und Propylenoxid und/oder anderen 1-Alkenoxiden, Poly(THF), Polyester-, Polycarbonat- und Polyacrylatpolyole mit zahlenmittleren Molmassen bis 10000 g/Mol oder deren beliebige Gemische untereinander.

Beim Prepolymeraufbau wird zur Allophanatisierung zunächst ein Isocyanat gemäß A1) mit einem Alkohol gemäß A2) in stöchiometrischem Verhältnis zu einem Urethan umgesetzt, welches anschließend mit einem weiteren Isocyanat umgesetzt wird, wobei ein Allophanat entsteht. Als Alkohol eignen sich in diesem Falle für die Umsetzung mit den erwähnten Di-, Tri- oder Polyisocyanaten zum Urethan alle oligomeren oder polymeren, sekundären, difunktionellen Alkohole der vorstehend beschriebenen Art. Für die weitere Umsetzung zum Allophanat werden bevorzugt die monomeren Di- oder Triisocyanate HDI, TMDI und TIN zugesetzt.

Bevorzugte Prepolymere sind Urethane oder Allophanate aus aliphatischen Isocyanat-funktionellen Verbindungen und oligomeren oder polymeren Isocyanat-reaktiven Verbindungen, wobei die Prepolymere zahlenmittlere Molmassen von 200 bis 10000 g/Mol und NCO-Funktionalitäten von 1.9 bis 5.0 aufweisen. Besonders bevorzugt sind Urethane mit NCO-Funktionalitäten von 1.9 bis 2.1 und zahlenmittleren Molmassen von 650 bis 8200 g/Mol. hergestellt aus aliphatischen Isocyanat-funktionellen Verbindungen und oligomeren oder polymeren Polyolen und Allophanate mit Funktionalitäten von größer 2.0 bis 3.2 oder von 3.9 bis 4.2 mit zahlenmittleren Molmassen von 650 bis 8200 g/Mol, hergestellt aus aliphatischen Isocyanat-funktionellen Verbindungen und oligomeren oder polymeren Polyolen oder deren beliebige Mischungen. Ganz besonders bevorzugt sind Urethane mit NCO-Funktionalitäten von 1,9 bis 2,1 und zahlenmittleren Molmassen von 1900 bis 4100 g/Mol, hergestellt aus aliphatischen Isocyanat-funktionellen Verbindungen und oligomeren oder polymeren Polyolen und Allophanate mit Funktionalitäten von größer 2.0 bis 3.2 oder von 3.9 bis 4.2 mit zahlenmittleren Molmassen von 1900 bis 4100 g/Mol, hergestellt aus aliphatischen Isocyanat-funktionellen Verbindungen und oligomeren oder polymeren Polyolen oder deren beliebige Mischungen.

Bevorzugt weisen die vorstehend beschriebenen Prepolymere Restgehalte an freiem monomeren Isocyanat von weniger als 1 Gew.-%, besonders bevorzugt weniger als 0.5 Gew.-%, ganz besonders bevorzugt weniger als 0.2 Gew.-% auf.

Selbstverständlich kann Komponente A) anteilsmäßig neben den beschriebenen erfindungswesentlichen Prepolymeren weitere Isocyanate enthalten. Hierfür kommen in Betracht aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)octan, 2,2,4- und/oder 2,4,4-Trimethylhexamethylendiisocyanat (TMDI), die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, Triphenylmethan-4,4',4"-triisocyanat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind Polyisocyanate auf Basis oligomerisierter und/oder derivatisierter Diisocyanate, die durch geeignete Verfahren von überschüssigem Diisocyanat befreit wurden, insbesondere die des Hexamethylendiisocyanat. Besonders bevorzugt sind die oligomeren Isocyanurate, Uretdione und Iminooxadiazindione des HDI sowie deren Mischungen.

Es ist gegebenenfalls auch möglich, dass die vorgenannten Isocyanatkomponente A) vollständig oder anteilsmäßig Isocyanate enthält, die ganz oder teilweise mit dem Fachmann aus der Beschichtungstechnologie bekannten Blockierungsmitteln umgesetzt sind. Als Beispiel für Blockierungsmittel seien genannt: Alkohole, Lactame, Oxime, Malonester, Alkylacetoacetate, Triazole, Phenole, Imidazole, Pyrazole sowie Amine, wie z.B. Butanonoxim, Diisopropylamin, 1,2,4-Triazol, Dimethyl-1,2,4-triazol, Imidazol, Malonsäurediethylester, Acetessigester, Acetonoxim, 3,5-Dimethylpyrazol, ε-Caprolactam, N-tert.-Butyl-benzylamin, Cyclopentanoncarboxyethylester oder beliebige Gemische dieser Blockierungsmittel.

Bevorzugt werden in A) ausschließlich die oben beschriebenen erfindungswesentlichen Prepolymere eingesetzt.

Als Komponente B) können an sich alle polyfunktionellen, isocyanatreaktiven Polyetherpolyole eingesetzt werden, die bevorzugt im Mittel wenigstens 1,5 isocyanatreaktive-Gruppen pro Molekül aufweisen.

Isocyanatreaktive Gruppen im Rahmen der vorliegenden Erfindung sind bevorzugt Hydroxyverbindungen.

Geeignete polyfunktionelle, isocyanatreaktive Verbindungen der vorstehend genannten Art sind beispielsweise Polyester-, Polyether-, Polycarbonat-, Poly(meth)acrylat- und/oder Polyurethanpolyole, bevorzugt hydroxyfunktionelle Polyetherpolyole.

Polyetherpolyole sind gegebenenfalls blockweise aufgebaute Polyadditionsprodukte cyclischer Ether an OH-funktionelle Startermoleküle. Geeignete cyclische Ether sind beispielsweise Styroloxide, Ethylenoxid, Propylenoxid, Tetrahydrofuran, Butylenoxid, Epichlorhydrin, sowie ihre beliebigen Mischungen.

Als Starter können mehrwertigen Alkohole einer OH-Funktionalität $\geq$ 2 sowie primäre oder sekundäre Amine und Aminoalkohole verwendet werden. Beispiele dafür sind Ethandiol, Di-, Tri-, Tetraethylenglykol, 1,2-Propandiol, Di-, Tri-, Tetrapropylenglykol, 1,3-Propandiol, Butandiol-1,4, Butandiol-1,3, Butandiol-2,3, Pentandiol-1,5, Hexandiol-1,6, 2,2-Dimethyl-1,3-propandiol, 1,4-Dihydroxycyclohexan, 1,4-Dimethylolcyclohexan, Octandiol-1,8, Decandiol-1,10, Dodecandiol-1,12, Trimethylolpropan, Glycerin oder deren beliebige Gemische untereinander.

Solche Polyetherpolyole haben bevorzugt zahlenmittlere Molmassen von 500 bis 8500 g/Mol, besonders bevorzugt von 1000 bis 6500 g/Mol und ganz besonders bevorzugt von 1900 bis 4500 g/Mol. Die OH-Funktionalität beträgt bevorzugt 1.5 bis 4.0, besonders bevorzugt 1.8 bis 3.0.

Daneben sind als Bestandteile der Komponente B) auch niedermolekulare, d.h. mit Molekulargewichten kleiner 500 g/Mol, kurzkettige, d.h. 2 bis 20 Kohlenstoffatome enthaltende aliphatische, araliphatische oder cycloaliphatische di-, tri- oder polyfunktionelle Alkohole enthalten. Bevorzugt ist der Einsatz reiner hydroxyfunktioneller Polyetherpolyole.

Bevorzugte Verbindungen der Komponente B) sind Poly(propylenoxid)e, Poly(ethylenoxide) und deren Kombinationen in Form von statistischen oder Blockcopolymeren sowie Blockcopolymere aus Propylenoxid und/oder Ethylenoxid. Dabei ist der Ethylenoxidanteil bezogen auf Gewichtsprozent des gesamten Produktes bevorzugt kleiner als 55%, besonders bevorzugt entweder zwischen 55% und 45% oder kleiner als 30% und ganz besonders bevorzugt kleiner als 10%.

Als ganz besonders bevorzugte Verbindungen der Komponente B) sind difunktionelle Polyetherpolyole, basierend auf Propylenoxid und Ethylenoxid mit einem Ethylenoxidanteil von kleiner 10 Gewichtsprozent bezogen auf die Gesamtmasse des zugrundeliegenden Polyethers, und einer zahlenmittleren Molmasse zwischen 2000 und 4200 g/mol eingesetzt.

Die Komponenten A) und B) werden bei der Herstellung der Photopolymerformulierung in einem OH/NCO-Verhältnis zueinander eingesetzt von typischerweise 0.9 bis 1.2, bevorzugt 0.95 bis 1.05.

In Komponente C) werden Urethanacrylate und/oder Urethanmethacrylate mit mindestens einer aromatischen Struktureinheit und einem Brechungsindex von größer 1.50 bei 405 nm eingesetzt. Unter Urethan(meth)acrylaten versteht man Verbindungen mit mindestens einer Acrylat- bzw. Methacrylatgruppe, die zusätzlich über mindestens eine Urethanbindung verfügen. Es ist bekannt, dass solche Verbindungen durch Umsetzung eines Hydroxy-funktionellen (Meth)Acrylsäureesters mit einer Isocyanat-funktionellen Verbindung erhalten werden können.

Beispiele hierfür verwendbarer Isocyanate sind aromatische, araliphatische, aliphatische und cycloaliphatische Di-, Tri- oder Polyisocyanate. Es können auch Mischungen solcher Di-, Tri- oder Polyisocyanate eingesetzt werden. Beispiele geeigneter Di-, Tri- oder Polyisocyanate sind Butylendiisocyanat, Hexamethylendiisocyanat (HDI), Isophorondiisocyanat (IPDI), 1,8-Diisocyanato-4-(isocyanatomethyl)oktan, 2,2,4- und/oder 2,4,4-Trimethylhexamethylendiisocyanat, die isomeren Bis(4,4'-isocyanatocyclohexyl)methane und deren Mischungen beliebigen Isomerengehalts, Isocyanatomethyl-1,8-octandiisocyanat, 1,4-Cyclohexylendiisocyanat, die isomeren Cyclohexandimethylendiisocyanate, 1,4-Phenylendiisocyanat, 2,4- und/oder 2,6-Toluylendiisocyanat, 1,5-Naphthylendiisocyanat, 2,4'- oder 4,4'-Diphenylmethandiisocyanat, 1,5-Naphthylendiisocyanat, Triphenylmethan-4,4',4"-triisocyanat und Tris(p-isocyanatophenyl)thiophosphat oder deren Derivate mit Urethan-, Harnstoff-, Carbodiimid-, Acylharnstoff-, Isocyanurat-, Allophanat-, Biuret-, Oxadiazintrion-, Uretdion-, Iminooxadiazindionstruktur und Mischungen derselben. Bevorzugt sind dabei aromatische Di-, Tri- oder Polyisocyanate.

Als hydroxyfunktionelle Acrylate oder Methacrylate für die Herstellung von Urethanacrylaten kommen beispielsweise in Betracht Verbindungen wie 2-Hydroxyethyl(meth)acrylat, Polyethylenoxid-mono(meth)acrylate, Polypropylenoxidmono(meth)acrylate, Polyalkylenoxidmono(meth)-acrylate, Poly($\varepsilon$-caprolacton)mono(meth)acrylate, wie z.B. Tone® M100 (Dow, Schwalbach, DE), 2-Hydroxypropyl(meth)acrylat, 4-Hydroxybutyl(meth)acrylat, 3-Hydroxy-2,2-dimethylpropyl-(meth)acrylat, Hydroxypropyl(meth)acrylat, Acrylsäure-(2-hydroxy-3-phenoxypropylester), die hydroxyfunktionellen Mono-, Di- oder Tetraacrylate mehrwertiger Alkohole wie Trimethylolpropan, Glycerin, Pentaerythrit, Dipentaerythrit, ethoxyliertes, propoxyliertes oder alkoxyliertes Trimethylolpropan, Glycerin, Pentaerythrit, Dipentaerythrit oder deren technische Gemische. Bevorzugt sind 2-Hydroxyethylacrylat, Hydroxypropylacrylat, 4-Hydroxybutylacrylat und Poly($\varepsilon$-caprolacton)mono(meth)acrylate. Darüberhinaus sind als isocyanat-reaktive oligomere oder polymere ungesättigte Acrylat- und/oder Methacrylatgruppen enthaltende Verbindungen alleine oder in Kombination mit den vorgenannten monomeren Verbindungen geeignet. Ebenfalls verwendet werden können die an sich bekannten hydroxylgruppenhaltigen Epoxy(meth)acrylate mit OH-Gehalten von 20 bis 300 mg KOH/g oder hydroxylgruppenhaltige Polyurethan(meth)acrylate mit OH-Gehalten von 20 bis 300 mg KOH/g oder acrylierte Polyacrylate mit OH-Gehalten von 20 bis 300 mg KOH/g sowie deren Mischungen untereinander und Mischungen mit hydroxylgruppenhaltigen ungesättigten Polyestern sowie Mischungen mit Polyester(meth)acrylaten oder Mischungen hydroxylgruppenhaltiger ungesättigter Polyester mit Polyester(meth)acrylaten. Bevorzugt sind hydroxylgruppenhaltige Epoxyacrylate mit definierter Hydroxyfunktionalität. Hydroxylguppenhaltige Epoxy(meth)acrylate basieren insbesondere auf Umsetzungsprodukten von Acrylsäure und/oder Methacrylsäure mit Epoxiden (Glycidylverbindungen) von monomeren, oligomeren oder polymeren Bisphenol-A, Bisphenol-F, Hexandiol und/oder Butandiol oder deren ethoxylierten und/oder propoxylierten Derivaten. Bevorzugt sind weiterhin Epoxyacrylate mit definierter Funktionalität wie sie aus der bekannten Umsetzung von Acrylsäure und/oder Methacrylsäure und Glycidyl(meth)acrylat erhalten werden können.

Bevorzugt werden Urethan(meth-)acrylate der vorstehend genannten Art verwendet, die mindestens eine aromatische Struktureinheit aufweisen. Diese Urethan(meth-)acrylate besitzen Brechungsindizes von typischerweise größer 1.50, bevorzugt größer 1.55 und ganz besonders bevorzugt größer 1.58 bei 405 nm.

Besonders bevorzugte als Komponente C) zu verwendende Verbindungen sind Urethanacrylate und Urethanmethacrylate auf Basis aromatischer Isocyanate und 2-Hydroxyethylacrylat, Hydroxypropylacrylat, 4-Hydroxybutylacrylat, Polyethylenoxid-mono(meth)acrylat, Polypropylenoxid-mono(meth)acrylat, Polyalkylenoxidmono(meth)acrylat und Poly($\varepsilon$-caprolacton)mono(meth)-acrylate.

In einer ganz besonders bevorzugten Ausführungsform werden als Komponente C) die Additionsprodukte aromatischer Triisocyanate (ganz besonders bevorzugt Tris-(4-phenylisocyanato)-thiophosphat oder Trimere aromatischer Diisocyanate wie Toluylendiisocyanat) mit Hydroxyethylacrylat, Hydroxypropylacrylat, 4-Hydroxybutylacrylat eingesetzt. In einer weiteren ganz besonders bevorzugten Ausführungsform werden als Komponente C Additionsprodukte von 3-Thiomethyl-phenylisocyanat mit Hydroxyethylacrylat, Hydroxypropylacrylat, 4-Hydroxybutylacrylat eingesetzt.

Als Verbindungen der Komponente D) geeignet sind beispielsweise Inhibitoren und Antioxidantien wie sie z.B. in "Methoden der organischen Chemie" (Houben-Weyl), 4. Auflage, Band XIV/1, S. 433ff, Georg Thieme Verlag, Stuttgart 1961, beschrieben sind. Geeignete Stoffklassen sind beispielsweise Phenole wie z.B. 2,6-Di-tert-butyl-4-methylphenol, Kresole, Hydrochinone, Benzylalkohole wie z.B. Benzhydrol, ggf. auch Chinone wie z. B. 2,5-Di-*tert*.-Butylchinon, ggf. auch aromatische Amine wie Diisopropylamin oder Phenothiazin.

Bevorzugt sind 2,6-Di-*tert*.-butyl-4-methylphenol, Phenothiazin, p-Methoxyphenol, 2-Methoxy-p-hydrochinon und Benzhydrol.

Als Komponente E) werden ein oder mehrere Photoinitiatoren eingesetzt. Dies sind üblicherweise durch aktinische Strahlung aktivierbare Initiatoren, die eine Polymerisation der entsprechenden polymerisierbaren Gruppen auslösen. Photoinitiatoren sind an sich bekannte, kommerziell vertriebene Verbindungen, wobei zwischen unimolekularen (Typ I) und bimolekularen (Typ II) Initiatoren unterschieden wird. Desweiteren werden diese Initiatoren je nach chemischer Natur für die radikalische, die anionische (oder), die kationische (oder gemischte) Formen der vorgenannten Polymerisationen eingesetzt.

Hier eingesetzt werden Typ (II)-Initiatoren wie die in EP-A 0223587 beschriebenen Photoinitiatorsysteme bestehend aus einer Mischung aus einem Ammoniumarylborat und einem oder mehreren Farbstoffen. Als Ammoniumarylborat eignen sich beispielsweise Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat. Als Farbstoffe eignen sich beispielsweise Neu-Methylenblau, Thionin, Basic Yellow, Pinacynol Chlorid, Rhodamin 6G, Gallocyanin, Ethylviolett, Victoria Blue R, Celestine Blue, Chinaldinrot, Kristallviolett, Brilliant Grün, Astrazon Orange G, Darrow Red, Pyronin Y, Basic Red 29, Pyrillium I, Cyanin und Methylenblau, Azur A (Cunningham et al., RadTech'98 North America UV/EB Conference Proceedings, Chicago, Apr. 19-22, 1998).

Bevorzugte Photoinitiatoren E) sind Mischungen aus Tetrabutylammonium Tetrahexylborat, Tetrabutylammonium Triphenylhexylborat, Tetrabutylammonium Tris-(3-fluorphenyl)-hexylborat und Tetrabutylammonium Tris-(3-Chlor-4-methylphenyl)-hexylborat (Komponente E1)) mit Farbstoffen wie beispielsweise Astrazon Orange G, Methylenblau, Neu Methylenblau, Azur A, Pyrillium I, Safranin O, Cyanin, Gallocyanin, Brilliant Grün, Kristallviolett, Ethylviolett und Thionin (Komponente E2)). Insbesondere bevorzugt ist die Kombination von je einem blau-sensitiven, einem grün-sensitiven sowie einem rot-sensitiven Farbstoff (z.B. Astrazon Orange G, Ethylviolett und Neu Methylenblau) und einem der vorgenannten Boratsalze.

Als Verbindungen der Komponente F) können gegebenenfalls ein oder mehrere Katalysatoren eingesetzt werden. Dabei handelt es sich um Katalysatoren zur Beschleunigung der Urethanbildung. Bekannte Katalysatoren hierfür sind beispielsweise Zinnoctoat, Zinkoctoat, Dibutylzinndilaurat, Dimethylbis[(1-oxoneodecyl)oxy]stannan, Dimethylzinndicarboxylat, Zirkonium-bis(ethyl-hexanoat), Zirconium-acetylacetonat oder tertiäre Aminen wie beispielsweise 1,4-Diazabi-cyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Bevorzugt sind Dibutylzinndilaurat, Dimethylbis[(1-oxoneodecyl)oxy]stannan, Dimethylzinndicarboxylat, 1,4-Diazabicyclo[2.2.2]octan, Diazabicyclononan, Diazabicycloundecan, 1,1,3,3-Tetramethylguanidin, 1,3,4,6,7,8-Hexahydro-1-methyl-2H-pyrimido(1,2-a)pyrimidin.

Für die Druckanwendung ist es wesentlich Zusatzstoffe G) einzusetzen, um eine verdruckbare Zusammensetzung zu erzielen, welche auch ein befriedigendes Druckbild liefert. Dabei kann es sich beispielsweise um im Bereich der Lacktechnologie gängige Zusatzstoffe wie Lösemittel, Weichmacher, Verlaufsmittel, Entschäumungsmittel oder Haftvermittler handeln. Als Weichmacher werden dabei bevorzugt Flüssigkeiten mit guten Löseeigenschaften, geringer Flüchtigkeit und hoher Siedetemperatur eingesetzt. Als Verlaufsmittel können oberflächenaktive Verbindungen wie z.B. Polydimethylsiloxane verwendet werden. Es kann auch von Vorteil sein, gleichzeitig mehrere Zusatzstoffe eines Typs zu verwenden. Selbstverständlich kann es ebenfalls von Vorteil sein, mehrere Zusatzstoffe mehrerer Typen zu verwenden.

Die erfindungsgemäßen Photopolymerformulierungen weisen in Komponente A) bevorzugt mindestens 10 Gew.-%, besonders bevorzugt wenigstens 15 Gew.-% und ganz besonders bevorzugt mindestens 20 Gew.-% bezogen auf die Photopolymerformulierungen an den erfindungswesentlichen ungesättigten Urethanen C) als Schreibmonomere auf. Der Anteil dieser Schreibmonomere C) an der Gesamtformulierung beträgt jedoch bevorzugt nicht mehr als 70 Gew.-%, besonders bevorzugt nicht mehr als 50 Gew.-%.

Zum Erzielen eines guten Druckbildes sind neben der Einstellung einer geeigneten und an das gewählten Druckverfahren angepasste Viskosität auch die Oberflächenspannung der Photopolymer-Formulierung anzupassen, um die Verläufe und die Stabilität des Druckbildes zu gewährleisten. Dies gelingt z. B. durch den Zusatz geeigneter Additive zum Entmischen, Entschäumen, oder Verlaufen. Diese können durch dem Fachmann geläufige Versuche mit polyestermodifizierten Polydimethylsiloxanen, fluormodifizierten Polymeren, schaumzerstörenden Polysiloxanen, hydrophoben Feststoffen und Emulgatoren, polyethermodifizierter Polymethylalkylsiloxans oder nicht ionischen Polyacrylat-Copolymeren in Reihenversuchen geprüft und in Abstimmung mit der Druckmaschine optimiert werden.

Typische Photopolymerzusammensetzungen umfassen:

10 bis 30 Gew.-% der Komponenten A),
25 bis 74.497 Gew.-% der Komponente B),
10 bis 40 Gew.-% der Komponente C)
0 bis 1 Gew.-% Radikalstabilisatoren D)
0.5 bis 3 Gew.-% Photoinitiatoren E1)
jeweils 0.001 bis 0.2 Gew.-% der drei Farbstoffe E2), die im Absorptionsspektrum auf die Laserwellenlängen rot, grün und blau abgestimmt sind
0 bis 4 Gew.-% Katalysatoren F)
5 bis 25 Gew.-% Hilfs- und Zusatzstoffe G)

Bevorzugt umfassen die erfindungsgemäßen Polyurethanzusammensetzungen
15 bis 30 Gew.-% der Komponenten A)
30 bis 56.96 Gew.-% der Komponente B),
20 bis 35 Gew.-% der Komponente C)
0.01 bis 0.5 Gew.-% Radikalstabilisatoren D)
1 bis 3 Gew.-% Photoinitiatoren E1)
jeweils 0.01 bis 0.2 Gew.-% der drei Farbstoffe E2), die im Absorptionsspektrum auf die Laserwellenlängen rot, grün und blau abgestimmt sind
0 bis 1 Gew.-% Katalysatoren F)
7 bis 20 Gew.-% Hilfs- und Zusatzstoffe G)
Besonders bevorzugt umfassen die erfindungsgemäßen Polyurethanzusammensetzungen
17 bis 30 Gew.-% Komponente A)
40 bis 48.37 Gew.-% der Komponenten B)
25 Gew.-% der Komponente C)
0.02 bis 0.1 Gew.-% Radikalstabilisatoren D)
1 bis 1,5 Gew.-% Photoinitiatoren E1)
jeweils 0.03 bis 0.1 Gew.-% der drei Farbstoffe E2), die im Absorptionsspektrum auf die Laserwellenlängen rot, grün und blau abgestimmt sind
0.02 bis 0.1 Gew.-% Katalysatoren F)
8 bis 15 Gew.-% Hilfs- und Zusatzstoffe G)
Ein weiterer Gegenstand der vorliegenden Erfindung ist der Artikel, der durch Bedrucken eines transparenten Substrates als Trägerschicht (I) mit der erfindungswesentlichen präpolymerbasierten Polyurethanformulierung erhalten wird.

Bevorzugte Materialien oder Materialverbünde der Trägerschicht (I) basieren auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral oder Polydicyclopentadien oder deren Mischungen. Daneben können Materialverbünde wie Folienlaminate oder Coextrudate als Trägerfolie (I) Anwendung finden. Beispiele für Materialverbünde sind Duplex- und Triplexfolien aufgebaut nach einem der Schemata A/B, A/B/A oder A/B/C wie PC/PET, PET/PC/PET und PC/TPU (TPU = Thermoplastisches Polyurethan). Besonders bevorzugt wird PC und PET als Trägerfolie (I) verwendet.

Bevorzugt sind transparente Träger (I), die optisch klar, d.h. nicht trüb sind. Die Trübung (engl. Haze) ist messbar über den Haze-Wert, welcher kleiner als 3.5%, bevorzugt kleiner als 1%, besonders bevorzugt kleiner als 0.3% ist.

Der Haze-Wert beschreibt den Anteil des transmittierten Lichts, der von der durchstrahlten Probe nach vorne gestreut wird. Somit ist er ein Maß für die Opazität oder Trübung transparenter Materialien und quantifiziert Materialfehler, Partikel, Inhomogenitäten oder kristalline Phasengrenzen in dem Material oder seiner Oberfläche, die die klare Durchsicht stören. Das Verfahren zur Messung der Trübung wird in der Norm ASTM D 1003 beschrieben.

Bevorzugt weist der Träger (I) eine nicht zu hohe Doppelbrechung auf, d.h. typischerweise eine mittlere optische Retardation von weniger als 1000 nm, bevorzugt von weniger als 700 nm, besonders bevorzugt von weniger als 300 nm auf.

Die Retardation R ist das mathematische Produkt aus der Doppelbrechung $\Delta n$ und der Dicke des Trägers d. Die automatische und objektive Messung der Retardation erfolgt mit einem bildgebenden Polarimeter, z.B. von der Firma ilis GmbH, Modell StainMatic® M3/M.

Die Retardation wird in senkrechter Inzidenz gemessen. Die für den Träger (I) angegebenen Werte für die Retardation sind laterale Mittelwerte.

Der Träger (I) hat, einschließlich eventueller ein oder beidseitiger Beschichtungen, typischerweise eine Dicke von 5 bis 2000 $\mu$m, bevorzugt 8 bis 300 $\mu$m, besonders bevorzugt 30 bis 200 $\mu$m und insbesondere 125 bis 175 $\mu$m oder 30 bis 45 $\mu$m.

Die durch Drucken aufgebrachten Photopolymerlagen (II) haben bevorzugt eine Gesamtschichtdicke bezogen auf alle in Schicht (II) aufgebrachten Photopolymerlagen von höchstens 200 $\mu$m, besonders bevorzugt 3 bis 100 $\mu$m, ganz besonders bevorzugt 15 bis 60 $\mu$m.

Zusätzlich zu den Bestandteilen (I) und (II) kann der Folienverbund ein oder mehrere Abdeckschichten (III) auf der Photopolymerschicht (II) aufweisen, um diese vor Schmutz und Umwelteinflüssen zu schützen. Hierzu können Kunststofffolien oder Folienverbundsysteme, aber auch Klarlacke verwendet werden.

Als Abdeckschichten (III) werden bevorzugt Folienmaterialien analog den in der Trägerschicht eingesetzten Materialien verwendet, wobei diese eine Dicke von typischerweise 5 bis 200 $\mu$m, bevorzugt 8 bis 125 $\mu$m, besonders bevorzugt 20 bis 50 $\mu$m.

Bevorzugt sind Abdeckschichten (III) mit einer möglichst glatten Oberfläche. Als Maß gilt die Rauigkeit bestimmt nach DIN EN ISO 4288 "Geometrische Produktspezifikation (GPS) - Oberflächenbeschaffenheit..." (engl. "Geometrical Product Specifications (GPS) - Surface texture...", Prüfbedingung R3z Vorderseite und Rückseite. Bevorzugte Rauigkeiten liegen im Bereich kleiner oder gleich 2 $\mu$m, bevorzugt kleiner oder gleich 0.5 $\mu$m.

Als Abdeckschichten (III) werden bevorzugt PE- oder PET-Folien einer Dicke von 20 bis 60 $\mu$m verwendet, besonders bevorzugt wird eine Polyethylenfolie von 40 $\mu$m Dicke verwendet.

Es können weitere Schutzschichten, so z.B. eine untere Kaschierung der Trägerfolie (I) Anwendung finden.

Das erfindungsgemäße Druckverfahren zur Herstellung von Filmen und Lacken und die Aufzeichnung visueller Hologramme wird bevorzugt derart durchgeführt, dass die Aufbaukomponenten der erfindungsgemäßen Polyurethanzusammensetzungen mit Ausnahme der Komponente A) miteinander homogen vermischt werden und unmittelbar vor der Applikation auf das Substrat oder in die Form erst Komponente A) zugemischt wird.

Für die Förderung und die benötigte Genauigkeit beim Dosieren eignen sich alle dem Fachmann bekannten Pumpensysteme, die im Speziellen gegendruckunabhängig, pulsationsarm und präzise fördern. Bevorzugt werden demnach Membranpumpe, Zahnradpumpen, Excenterschneckenpumpen (Mohnopumpen), Schlauchpumpen und Kolbenpumpen. Besonders bevorzugt sind Zahnradpumpen und Excenterschneckenpumpen (Mohnopumpen).

Bevorzugte Dosiermengen sind im Bereich von 2 ml/min bis 1.000 ml/min, besonders bevorzugt im Bereich von 2 ml/min bis 100 ml/min.

Zur Vermischung können alle dem Fachmann aus der Mischungstechnik an sich bekannten Verfahren und Apparate, wie beispielsweise Rührkessel oder sowohl dynamische als auch statische Mischer verwendet werden. Bevorzugt sind allerdings Apparate ohne oder mit nur geringen Toträumen. Weiterhin sind Verfahren bevorzugt, in denen die Vermischung innerhalb sehr kurzer Zeit und mit sehr starker Durchmischung der beiden zu mischenden Komponenten erfolgt. Hierfür eignen sich insbesondere dynamische Mischer, insbesondere solche, in denen die Komponenten erst im Mischer miteinander in Kontakt kommen.

Die Temperaturen betragen dabei 0 bis 100 °C, bevorzugt 10 bis 80 °C, besonders bevorzugt 20 bis 60 °C.

Falls notwendig kann auch eine Entgasung der einzelnen Komponenten oder der gesamten Mischung unter einem reduzierten Druck von beispielsweise 1 mbar durchgeführt werden. Ein Entgasen, insbesondere nach Zugabe der Komponente A) ist bevorzugt, um Blasenbildung durch Restgase in den erhältlichen Medien zu verhindern.

Vor Zumischung der Komponente A) können die Mischungen als lagerstabiles Zwischenprodukt gegebenenfalls über mehrere Monate gelagert werden kann.

Nach der Zumischung der Komponente A) der erfindungsgemäßen Polyurethanzusammensetzungen wird eine klare, flüssige Formulierung erhalten, die je nach Zusammensetzung bei Raumtemperatur innerhalb weniger Sekunden bis zu einigen Stunden aushärtet.

Das Verhältnis sowie die Art und Reaktivität der Aufbaukomponenten der Polyurethanzusammensetzungen wird bevorzugt so eingestellt, dass die Aushärtung nach Zumischung der Komponente A) bei Raumtemperatur innerhalb von Minuten bis zu einer Stunde eintritt. In einer bevorzugten Ausführungsform wird die Aushärtung beschleunigt indem die Formulierung nach der Zumischung auf Temperaturen zwischen 30 und 180 °C, bevorzugt 40 bis 120 °C, besonders bevorzugt 50 bis 100 °C erwärmt wird.

Die vorgenannte Einstellung hinsichtlich des Aushärteverhaltens ist für einen Fachmann in Form von Routineversuchen innerhalb der oben angegebenen Mengenbereich der Komponenten sowie der jeweils zur Auswahl stehenden, insbesondere den bevorzugten Aufbaukomponenten, leicht möglich.

Die erfindungsgemäßen Polyurethanzusammensetzungen besitzen unmittelbar nach vollständiger Vermischung aller Komponenten Viskositäten bei 25°C von typischerweise 10 bis 100000 mPas, bevorzugt 100 bis 20000 mPas, besonders bevorzugt 200 bis 10000 mPas, insbesondere bevorzugt 500 bis 5000 mPas so dass sie bereits in lösemittelfreier Form sehr gute verarbeitungstechnische Eigenschaften besitzen. In Lösung mit geeigneten Lösemitteln können Viskositäten bei 25°C unterhalb 10000 mPas, bevorzugt unterhalb 2000 mPas, besonders bevorzugt unterhalb 500 mPas eingestellt werden.

Als vorteilhaft haben sich Polyurethanzusammensetzungen der vorstehend genannten Art erwiesen, die mit einem Katalysatorgehalt von 0.004 Gew.-% bis 0.1 Gew.-% bei 80°C unter 6 Minuten aushärten, bevorzugt werden Konzentrationen zwischen 0.01 Gew.-% und 0.08 Gew.-%, besonders bevorzugt werden Konzentrationen zwischen 0.03 Gew.-% und 0.06 Gew.-% .

Zur Applikation auf ein Substrat sind alle jeweiligen gängigen, dem Fachmann bekannten Druckverfahren geeignet, wie insbesondere Rakeln, Gießen, Drucken, Siebdruck, Spritzen, oder InkJet-Druck. Bevorzugte Applikationsverfahren sind Siebdruck und InkJet-Druck.

Unter Druckverfahren werden im Allgemeinen Arbeitsweisen und -methoden zur Vervielfältigung zweidimensionaler Vorlagen verstanden. Bei älteren Druckverfahren wird die Druckfarbe von einer Vorlage auf das zu bedruckende Gut durch eine Druckmaschine übertragen; neuere Druckverfahren nutzen hierfür digitale Drucksysteme. Die erstgenannten Druckverfahren gliedern sich in die Fertigungsphasen Druckformenherstellung und Fortdruck. Nach der Eigenart der Druckform werden verschiedene Druckverfahren unterschieden.

Beim Hochdruck stehen alle druckenden Stellen erhaben in einer Ebene, werden eingefärbt und geben die Druckfarbe an den Bedruckstoff ab. Im Buchdruck besteht die Druckform aus Drucktypen und/oder Maschinensatzzeilen, Stereos und Galvanos; beim indirekten Hochdruck (Lettersetdruck) aus einer meist geätzten, rund gebogenen Metallplatte (Wickelplatte); beim Flexodruck (Flexografie, veraltet Anilin-, Anilingummi-, Gummidruck) aus flexiblem Gummi oder Kunststoff. Beim Flachdruck liegen druckende und nicht druckende Druckformenstellen praktisch in einer Ebene. Die Druckform ist chemisch so behandelt, dass sie nur an den druckenden Stellen Farbe annimmt.

Beim Tiefdruck wird in die vertieft liegenden druckenden Stellen dünnflüssige Farbe eingebracht und die Oberfläche der Druckform durch Rakel wieder gereinigt, worauf der Abdruck erfolgt (Rakeltiefdruck [Raster-Kupfertiefdruck], Linientiefdruck, Stahlstichdruck u. a.).

Beim Siebdruck (Durchdruck) wird die Druckfarbe durch eine Schablone (siebartige Bespannung z. B. aus Chemieseide, eines Druckrahmens), mit einem Rakel auf den Bedruckstoff gedrückt.

Beim Tampondruck oder indirekten Tiefdruck wird die Vorlage mit Hilfe eines Tampons (aus porösem Silikonkautschuk) von einer Fläche (meist Tiefdruckform) auf eine andere, zum Beispiel Tassen, Kugelschreiber übertragen und kann damit auch in die Vertiefung eines verformten Bedruckstoffes appliziert werden.

Beim Stempeldruck werden die einzelnen Druckformen auf den Druckstoff aufgedrückt.

Beim Frottage dient als Druckstock eine mit Text gravierte Marmor- Granit- oder Kalksteinplatte. Über diese Steindruckplatte legte man ein feuchtes Papier, das anschließend mit Lappen in die Vertiefungen der gravierten Texte gepresst wurde, wonach das Papier mit Tusche eingestrichen wurde, wobei die Vertiefungen weiß und lesbar blieben, und ein Negativabzug entsteht.

Bei der Pigmentographie, ist als selbständiges grafisches Verfahren im Gegensatz zum Pigmentdruck, am Ende der Durchdruck und Schablonendruckverfahren einzugliedern. Bei der von Al Bernstein in USA den 70er Jahren als Trace-Print ins Leben gerufenen Drucktechnik, werden die einzelnen Druckformen im Positiv-Negativ-Verfahren geschnitten und gestochen, wobei im Gegensatz zum Pochoir, sehr feine Linien und Punkte gedruckt werden Können. Beim Druckvorgang werden Druckfarbe, Farbpigmente, per Hand durch die Druckschablone durchgebürstet, und anschließend fixiert.

Bubble-Jet-Drucker erzeugen winzige Tintentropfen mit Hilfe eines Heizelements, welches das Wasser in der Tinte erhitzt. Dabei bildet sich explosionsartig eine winzige Dampfblase, die durch ihren Druck einen Tintentropfen aus der Düse presst. Hierbei kommen zwei Systeme zum Einsatz: Lexmark und HP bei der Deskjet-Reihe setzt auf flache Düsenelemente, die im Wesentlichen aus zwei Platten bestehen. Die dem Papier zugewandte enthält eine winzige Düsenbohrung und die Dampfblase bildet sich gegenüber dieser Bohrung (Sideshooter). Das Verfahren ist sehr einfach herzustellen und ist deswegen preiswert, hat aber den Nachteil einer begrenzten Lebensdauer der Druckköpfe. Es wird bei allen Wechseldruckköpfen verwendet. Canon arbeitet bei seinen Druckern mit einer Bubble-Jet-Technik, bei der sich die Düsen im rechten Winkel zu den Heizelementen befinden (Edgeshooter). Das Verfahren ist dem Piezo-Verfahren sehr ähnlich, nur dass der Auspressdruck nicht durch ein piezoelektrisches Element, sondern durch eine Dampfblase erzeugt wird. Das einzelne Heizelement arbeitet mit einer Frequenz bis 10 kHz.

Piezo-Drucker nutzen den Piezoelektrischen Effekt in piezoelektrischen Keramikelementen, sich unter elektrischer Spannung zu verformen, um Drucktinte durch eine feine Düse zu pressen. Es erfolgt eine Tropfenbildung der Tinte, deren Tropfenvolumen sich über die Größe des angelegten elektrischen Impulses steuern lässt. Die Arbeitsfrequenz eines Piezokristalls reicht bis zu 23 kHz.

Bei Druck-Ventil-Druckern sind einzelne Ventile an den Düsen angebracht, die sich öffnen, wenn ein Tropfen die Düse verlassen soll.

Ein weiterer Gegenstand der vorliegenden Erfindung ist die Verwendung der erfindungsgemäßen bedruckten Artikel zur Aufzeichnung visueller Hologramme, zur Herstellung von optischen Elementen, Bildern, Darstellungen sowie ein Verfahren zur Aufzeichnung von Hologrammen unter Verwendung der erfindungsgemäßen Polyurethanzusammensetzungen und den daraus zugänglichen Medien oder holographischen Filmen.

Mit den erfindungsgemäßen Polyurethanzusammensetzungen können durch entsprechende Belichtungsprozesse Hologramme für optische Anwendungen im gesamten sichtbaren Bereich sowie im nahen UV-Bereich (300 - 800 nm) hergestellt werden. Visuelle Hologramme umfassen alle Hologramme, die nach dem Fachmann bekannten Verfahren aufgezeichnet werden können, darunter fallen unter anderem In-Line (Gabor) Hologramme, Off-Axis Hologramme, Full-Aperture Transfer Hologramme, Weißlicht-Transmissionshologramme ("Regenbogenhologramme"), Denisyukhologramme, Off-Axis Reflektionshologramme, Edge-Lit Hologramme sowie Holographische Stereogramme, bevorzugt sind Reflexionshologramme, Denisyukhologramme, Transmissionshologramme. Bevorzugt sind optische Elemente wie Linsen, Spiegel, Umlenkspiegel, Filter, Streuscheiben, Beugungselemente, Lichtleiter, Lichtlenker (waveguides), Projektionsscheiben und/oder Masken. Häufig zeigen diese optischen Elemente eine Frequenzselektivität je nachdem wie die Hologramme belichtet wurden und welche Dimensionen das Holgramm hat.

Zudem können mittels der erfindungsgemäßen Polyurethanzusammensetzungen auch holographische Bilder oder Darstellungen hergestellt werden, wie zum Beispiel für persönliche Portraits, biometrische Darstellungen in Sicherheitsdokumenten, oder allgemein von Bilder oder Bildstrukturen für Werbung, Sicherheitslabels, Markenschutz, Markenbranding, Etiketten, Designelementen, Dekorationen, Illustrationen, Sammelkarten, Bilder und dergleichen sowie Bilder, die digitale Daten repräsentieren können u.a. auch in Kombination mit den zuvor dargestellten Produkten. Holographische Bilder können den Eindruck eines dreidimensionalen Bildes haben, sie können aber auch Bildsequenzen, kurze Filme oder eine Anzahl von verschiedenen Objekten darstellen, je nachdem aus welchem Winkel, mit welcher (auch bewegten) Lichtquelle etc. diese beleuchtet wird. Aufgrund dieser vielfältigen Designmöglichkeiten stellen Hologramme, insbesondere Volumenhologramme, eine attraktive technische Lösung für die oben genannten Anwendung dar.

**Beispiele:**

Einsatzstoffe:

Desmodur® XP 2599 ist ein Versuchsprodukt der Bayer MaterialScience AG, Leverkusen, DE, Vollallophanat von Hexandiisocyanat auf Acclaim 4200, NCO-Gehalt: 5.6 - 6.4 %

Polyol 1 (Acclaim® 4200) ist ein Polypropylenoxid der zahlenmittleren Molmasse 4000 g/Mol der Bayer MaterialScience AG, Leverkusen, DE.

Urethanacrylat 1 ist ein experimentelles Produkt der Bayer MaterialScience AG, Leverkusen, DE, Urethanacrylat auf Basis von 2-Hydroxyethylacrylat und Tris(p-isocyanatophenyl)thiophosphat.

Fomrez® UL28: Urethanisierungskatalysator, Dimethylbis[(1-oxoneodecyl)oxy]stannan, Handelsprodukt der Fa. Momentive Performance Chemicals, Wilton, CT, USA (als 10%ige Lösung in N-Ethylpyrrolidon eingesetzt).

CGI 909 ist ein im Jahr 2009 von der Fa. Ciba Inc., Basel, Schweiz vertriebenes Versuchsprodukt.

Neu Methylenblau (zinkfrei): Farbstoff der Fa. Sigma-Aldrich Chemie GmbH, Steinheim, Deutschland.

Ethylviolett: Farbstoff der Fa.MP Biomedicals LLC, Solon, Ohio, USA.

Astrazon Orange G: Farbstoff der Fa. Sigma-Aldrich Chemie GmbH, Steinheim, Deutschland.

Byk 310: silikonbasiertes Oberflächenadditiv der Fa. BYK-Chemie GmbH, Wesel, Deutschland (Lösung ca. 25%-ig in Xylol), zahlenmittlere Molmasse ca. 2200 g/mol.

**Messung von Beugungswirkungsgrad DE und Brechungsindexkontrast Δn:**

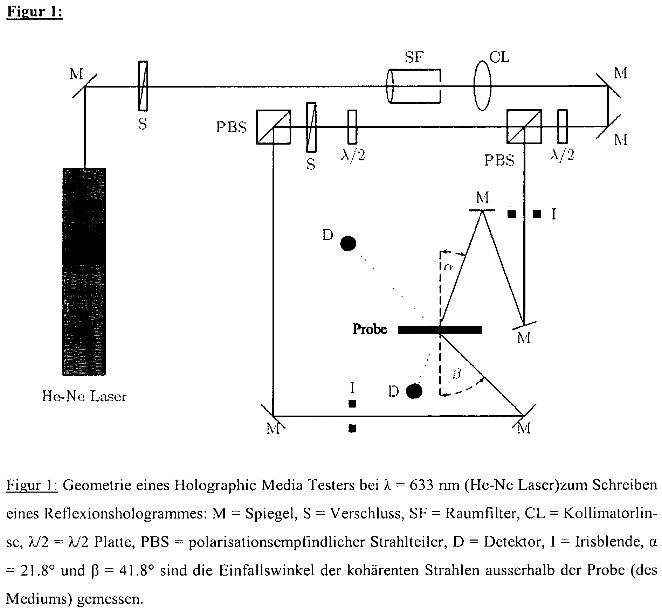

Die im Rahmen des experimentellen Teils hergestellten erfindungsgemäßen und Vergleichsmedien wurden mittels einer Messanordnung gemäß Figur 1 auf ihre holographischen Eigenschaften geprüft:

Dabei wird die Kaschierfolie vom Folienverbund abgezogen und das Photopolymermaterial anschließend so auf Glas laminiert, dass die Substratfolie nach außen zeigt.

Der Strahl eines He-Ne Lasers (Emissionswellenlänge 633 nm) wurde mit Hilfe des Raumfilter (SF) und zusammen mit der Kollimationslinse (CL) in einen parallelen homogenen Strahl umgewandelt. Die finalen Querschnitte des Signal und Referenzstrahls werden durch die Irisblenden (I) festgelegt. Der Durchmesser der Irisblendenöffnung beträgt 4 mm. Die polarisationsabhängigen Strahlteiler (PBS) teilen den Laserstrahl in zwei kohärente gleich polarisierte Strahlen. Über die λ/2 Plättchen wurden die Leistung des Referenzstrahls auf 0.5 mW und die Leistung des Signalstrahls auf 0.65 mW eingestellt. Die Leistungen wurden mit den Halbleiterdetektoren (D) bei ausgebauter Probe bestimmt. Der Einfallswinkel (α) des Referenzstrahls beträgt 21.8°, der Einfallswinkel (β) des Signalstrahls beträgt 41.8°. Am Ort der Probe (Medium) erzeugte das Interferenzfeld der zwei überlappenden Strahlen ein Gitter heller und dunkler Streifen die senkrecht zur Winkelhalbierenden der zwei auf die Probe einfallenden Strahlen liegen (Reflexionshologramm). Der Streifenabstand im Medium beträgt ~ 225 nm (Brechungsindex des Mediums zu ~1.49 angenommen).

Es wurden auf folgende Weise Hologramme in das Medium geschrieben:

Beide Shutter (S) sind für die Belichtungszeit t geöffnet. Danach wurde bei geschlossenen Shuttern (S) dem Medium 5 Minuten Zeit für die Diffusion der noch nicht polymerisierten Schreibmonomere gelassen. Die geschriebenen Hologramme wurden nun auf folgende Weise ausgelesen. Der Shutter des Signalstrahls blieb geschlossen. Der Shutter des Referenzstrahls war geöffnet. Die Irisblende des Referenzstrahls wurde auf einen Durchmesser < 1 mm geschlossen. Damit erreichte man, dass für alle Drehwinkel (Ω) des Mediums der Strahl immer vollständig im zuvor geschriebenen Hologramm lag. Der Drehtisch überstrich nun computergesteuert den Winkelbereich von Ω = 0° bis Ω = 20° mit einer Winkelschrittweite von 0.05°. An jedem angefahrenen Winkel □□wurden die Leistungen des in der nullten Ordnung transmittierten Strahls mittels des entsprechenden Detektors D und die Leistungen des in die erste Ordnung abgebeugten Strahls mittels des Detektors D gemessen. Die Beugungseffizienz η ergab sich bei jedem angefahrenen Winkel Ω als der Quotient aus:

$$\eta = \frac{P_D}{P_D + P_T}$$

$P_D$ ist die Leistung im Detektor des abgebeugten Strahls und $P_T$ ist die Leistung im Detektor des transmittierten Strahls.

Mittels des oben beschriebenen Verfahrens wurde die Braggkurve, sie beschreibt den Beugungswirkungsgrad η in Abhängigkeit des Drehwinkels Ω□ des geschriebenen Hologramms gemessen und in einem Computer gespeichert. Zusätzlich wurde auch die in die nullte Ordnung transmittierte Intensität gegen der Drehwinkel Ω aufgezeichnet und in einem Computer gespeichert.

Die maximale Beugungseffizienz (DE = $\eta_{max}$) des Hologramms, also sein Spitzenwert, wurde ermittelt. Eventuell musste dazu die Position des Detektors des abgebeugten Strahls verändert werden, um diesen maximalen Wert zu bestimmen.

Der Brechungsindexkontrast Δn und die Dicke d der Photopolymerschicht wurde nun mittels der Coupled Wave Theorie (siehe; H. Kogelnik, The Bell System Technical Journal, Volume 48, November 1969, Number 9 Seite 2909 - Seite 2947) an die gemessene Braggkurve und den Winkelverlauf der transmittierten Intensität ermittelt. Das Verfahren wird im folgenden beschrieben:

Für die Braggkurve η/(Ω) eines Reflexionshologramms gilt nach Kogelnik:

$$\eta = \frac{1}{1 + \frac{1 - \left(\chi / \Phi\right)^2}{\sinh^2\left(\sqrt{\Phi^2 - \chi^2}\right)}}$$

mit:

$$\Phi = \frac{\pi \cdot \Delta n \cdot d}{\lambda \cdot \sqrt{\cos(\alpha') \cdot \cos(\alpha' - 2\psi)}}$$

$$\chi = \Delta\theta \cdot \frac{2\pi \cdot \sin(\alpha' - \psi)}{\Lambda \cdot \cos(\alpha' - 2\psi)} \cdot \frac{d}{2}$$

$$\psi = \frac{\beta' - \alpha'}{2}$$

$$\Lambda = \frac{\lambda}{2 \cdot n \cdot \cos(\psi - \alpha')}$$

$$n \cdot \sin(\alpha') = \sin(\alpha), \, n \cdot \sin(\beta') = \sin(\beta)$$

$$\Delta\theta = -\Delta\Omega \cdot \sqrt{\frac{1 - \sin^2(\alpha)}{n^2 - \sin^2(\alpha)}}$$

$\Phi$ ist die Gitterstärke, $\chi$ ist der Detuning Parameter und $\Psi$ der Kippwinkel des Brechungsindexgitters, das geschrieben wurde. $\alpha'$ und $\beta'$ entsprechen den Winkeln $\alpha$ und $\beta$ beim Schreiben des Hologramms, aber im Medium. $\Delta\Theta$ ist das Winkeldetuning gemessen im Medium, also die Abweichung vom Winkel $\alpha'$. $\Delta\Omega$ ist das Winkeldetuning gemessen außerhalb des Mediums, also die Abweichung vom Winkel $\alpha$. n ist der mittlere Brechungsindex des Photopolymers und wurde zu 1.504 gesetzt.

Die maximale Beugungseffizienz (DE = $\eta_{max}$) ergibt sich dann für $\chi = 0$, also $\Delta\Omega = 0$ zu:

$$DE = \tanh^2(\Phi) = \tanh^2\left(\frac{\pi \cdot \Delta n \cdot d}{\lambda \cdot \sqrt{\cos(\alpha') \cdot \cos(\alpha' - 2\psi)}}\right)$$

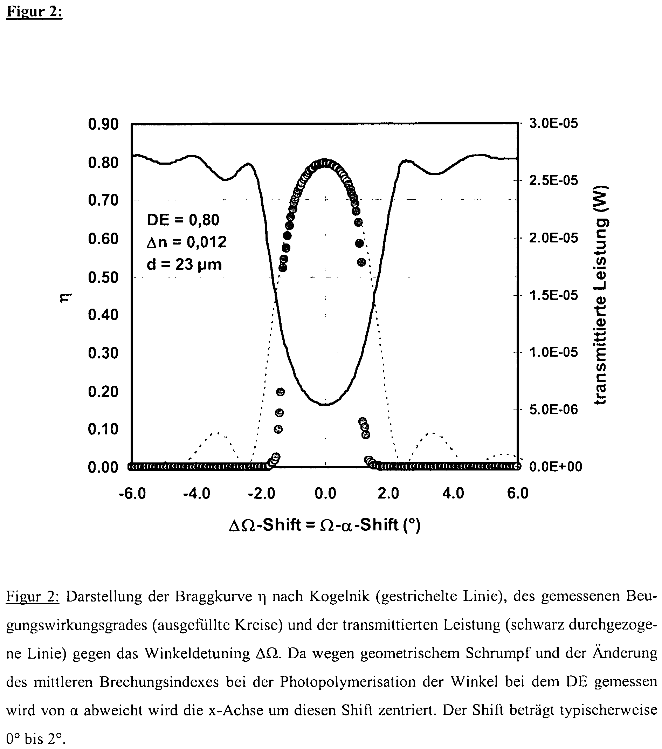

Die Messdaten der Beugungseffizienz, die theoretische Braggkurve und die transmittierte Intensität werden wie in Figur 2 gezeigt gegen den zentrierten Drehwinkel $\Omega$-$\alpha$-Shift aufgetragen. Da wegen geometrischem Schrumpf und der Änderung des mittleren Brechungsindexes bei der Photopolymerisation der Winkel bei dem DE gemessen wird von $\alpha$ abweicht wird die x-Achse um diesen Shift zentriert. Der Shift beträgt typischerweise 0° bis 2°.

Da DE bekannt ist wird die Form der theoretischen Braggkurve nach Kogelnik nur noch durch die Dicke d der Photopolymerschicht bestimmt. $\Delta n$ wird über DE für gegebene Dicke d so nachkorrigiert, dass Messung und Theorie von DE immer übereinstimmen. d wird nun solange angepasst bis die Winkelpositionen der ersten Nebenminima der theoretischen Braggkurve mit den Winkelpositionen der ersten Nebenmaxima der transmittierten Intensität übereinstimmen und zudem die volle Breite bei halber Höhe (FWHM) für theoretische Braggkurve und die transmittierte Intensität übereinstimmen.

Da die Richtung, in der ein Reflexionshologramm bei der Rekonstruktion mittels eines $\Omega$-Scans mitrotiert, der Detektor für das abgebeugte Licht aber nur einen endlichen Winkelbereich erfassen kann, wird die Braggkurve von breiten Holgrammen (kleines d) bei einem $\Omega$-Scan nicht vollständig erfasst, sondern nur der zentrale Bereich (bei geeigneter Detektorpositionierung). Daher wird die zur Braggkurve komplementäre Form der transmittierten Intensität zur Anpassung der Schichtdicke d zusätzlich herangezogen.

Für eine Formulierung wurde diese Prozedur eventuell mehrfach für verschiedene Belichtungszeiten t an verschiedenen Medien wiederholt, um festzustellen bei welcher mittleren Energiedosis des einfallenden Laserstrahls beim Schreiben des Hologramms DE in den Sättigungswert übergeht. Die mittlere Energiedosis E ergibt sich wie folgt:

$$E\,(\mathrm{mJ/cm}^2) = \frac{2 \cdot \left[0.50\,\mathrm{mW} + 0.67\,\mathrm{mW}\right] \cdot t\,(\mathrm{s})}{\pi \cdot 0.4^2\,\mathrm{cm}^2}$$

Die Leistungen der Teilstrahlen wurden so angepasst, dass in dem Medium bei den verwendeten Winkeln $\alpha$ und $\beta$, die gleiche Leistungsdichte erreicht wird.

**Herstellung des Urethanacrylates 1:**

In einem 500 mL Rundkolben wurden 0.1 g 2,6-Di-tert.-butyl-4-methylphenol, 0.05 g Dibutylzinndilaurat (Desmorapid Z, Bayer MaterialScience AG, Leverkusen, Deutschland) und 213.07 g einer 27 %-igen Lösung von Tris(p-isocyanatophenyl)thiophosphat in Ethylacetat (Desmodur® RFE, Produkt der Bayer MaterialScience AG, Leverkusen, Deutschland) vorgelegt und auf 60 °C erwärmt. Anschließend wurden 42.37 g 2-Hydroxyethylacrylat zugetropft und die Mischung weiter auf 60 °C gehalten, bis der Isocyanatgehalt unter 0.1 % gesunken war. Danach wurde abgekühlt und im Vakuum das Ethylacetat vollständig entfernt. Das Produkt wurde als teilkristalliner Feststoff erhalten.

Zur Herstellung der holographischen Medien werden die Komponente C, die Komponente D (die bereits in der Komponente C vorgelöst sein kann) sowie gegebenenfalls die Komponente G und F in der Komponente B gegebenenfalls bei 60 °C gelöst und gründlich gemischt. Danach wird im Dunklen oder unter geeigneter Beleuchtung die Komponente E in reiner Form oder in verdünnter Lösung in NEP zugewogen und erneut gemischt. Gegebenenfalls wird maximal 10 Minuten im Trockenschrank auf 60 °C erhitzt. Die erhaltene Mischung kann unter Rühren bei < 10 mbar entgast werden.

Die so erhaltene Photopolymerformulierung wird zum Siebdruck auf die vorbereitete Schablone aufgebracht und anschließend im halbautomatischen bzw vollautomischen Arbeitsgang verarbeitet. Hierzu können die Druckparameter wie z.B. die Rakelgeschwindigkeit dem Druckbild angepasst werden. Mit dem Rakel wird die Formulierung durch die Schablone (Gitternetz) auf das zu bedruckende Substrat gedrückt. Anschließend wird das Sieb wieder mit dem Flutrakel gefüllt und ein neuer Zyklus startet. Nach dem Bedrucken wird das Substrat aus der Siebdruckmaschine entfernt und getrocknet. Dies kann im nachgeschalteten Tunnletrockner oder aber auch im Hordenwagen bzw. Ofen separat durchgeführt werden.

Die bedruckten Substrate werden bei ca. 80 °C getrocknet und anschließend mit einer der oben genannten Abdeckschichten abgedeckt und in einer lichtdichten Verpackung verpackt.

Die Dicke d der Photopolymerschicht ergibt sich aus den dem Fachmann bekannten Beschichtungsparametern der entsprechenden Beschichtungseinrichtung.

Die folgenden Beispiele sind zur Erläuterung der erfindungsgemäßen Methode genannt, sollen aber nicht als begrenzend verstanden sein. Sofern nicht abweichend vermerkt beziehen sich alle Prozentangaben der Photopolymere auf Gewichtsprozent.

**Herstellung der druckbaren Formulierung:**

**Beispiel:**

26.1 g Polyol 1 wurden schrittweise mit 13.75 g Urethanacrylat 1, dann 0.028 g Fomrez® UL 28 und 2.75 g Byk 310, und zuletzt einer Lösung von 0.825 g CGI 909, 0.028 g Neu Methylenblau, 0.028 g Ethylviolett und 0.028 g Astrazon Orange G in 1.95 g N-Ethylpyrilidon im Dunkeln versetzt und gemischt, so dass eine klare Lösung erhalten wurde. Anschließend wurden bei 30 °C 9.45 g Desmodur® XP 2599 zugegeben und erneut gemischt. Die erhaltene, flüssige Masse wurde dann auf eine 175 $\mu$m dicke Polycarbonatfolie gedruckt, 10 Minuten bei 80°C getrocknet und mit einer PE Folie kaschiert.

**Druckbeispiel:**

An einer halbautomatischen Siebdruckmaschine AT-80 P der Fa. ESC wurde durch ein Sieb mit dem Gewebe PES 80 / 55 PW (VS-Monprint Polyester) die obige druckbare Formulierung gedruckt. Die offene Siebfläche bei diesem Gewebe liegt bei ca. 31%. Bei den Versuchen hat sich gezeigt, dass bei diesem Setup eine langsamere Rakelgeschwindigkeit ein besseres Druckbild gezeigt hat. Dies ist aber unabhängig zu sehen, da dies jeweils vom gesamten Zusammenspiel der einzelnen Komponenten (Rakelgummi, Rakelwinkel, Gewebeart etc.) abhängig ist. Es konnten mit der AT-80 P auch funktionsfähige Muster mit einer mittleren / schnelleren Rakelgeschwindigkeit erstellt werden.

Dabei ergaben sich folgende Messwerte für $\Delta$n bei der Dosis E:

| Beispiel | Siebweite | Rakelgeschwindigkeit | $\Delta$n | Dosis (mJ/cm$^2$) |
|---|---|---|---|---|
| 1 | 80 er Gewebe | 2 | 0.0083 | 9.23 |

Die gefundenen Werte für das $\Delta$n und die notwendige Dosis zeigen, dass die erfindungsgemäßen Photopolymere sich sehr gut als holographische Medien im Sinne der obigen Beschreibung eignen. Besonders gute holographische Medien können erhalten werden, wenn niedrige Rakelgeschwindigkeiten an einer Siebdruckmaschine eingestellt werden.

**Patentansprüche**

1. Polyurethanzusammensetzungen geeignet zum Verdrucken, umfassend

A) eine Polyisocyanatkomponente, wenigstens enthaltend ein NCO-terminiertes Polyurethanprepolymer dessen NCO-Gruppen primär aliphatisch gebunden sind und welches auf hydroxyfunktionellen Verbindungen mit einer OH-Funktionalität von 1.6 bis 2.05 basiert,
B) Isocyanat-reaktive Polyetherpolyole
C) Urethanacrylate und/oder Urethanmethacrylate mit mindestens einer aromatischen Struktureinheit und einem Brechungsindex von größer 1.50 bei 405 nm, die selbst frei von NCO-Gruppen und OH-Gruppen sind
D) Radikalstabilisatoren
E) Photoinitiatoren auf Basis von Kombinationen aus Boratsalzen und einem oder mehreren Farbstoffen mit Absorptionsbanden, die zumindest teilweise den Spektralbereich von 400 bis 800 nm abdecken
F) gegebenenfalls Katalysatoren
G) Hilfs- und Zusatzstoffe,

wobei in A) als Prepolymere Urethane oder Allophanate aus aliphatischen Isocyanat-funktionellen Verbindungen und oligomeren oder polymeren Isocyanat-reaktiven Verbindungen eingesetzt werden, wobei die Prepolymere zahlenmittlere Molmassen von 200 bis 10000 g/Mol und NCO-Funktionalitäten von 1.9 bis 5.0 aufweisen.

2. Polyurethanzusammensetzungen gemäß Anspruch 1, **dadurch gekennzeichnet, dass** in B) difunktionelle Polyetherpolyole, basierend auf Propylenoxid und Ethylenoxid mit einem Ethylenoxidanteil von kleiner 10 Gewichtsprozent bezogen auf die Gesamtmasse des zugrundeliegenden Polyethers, und einer zahlenmittleren Molmasse von 2000 bis 4200 g/mol eingesetzt.

3. Polyurethanzusammensetzungen gemäß einem der Ansprüche 1 bis 2, **dadurch gekennzeichnet, dass** in C) als Urethanacrylate Additionsprodukte aromatischer Triisocyanate oder Trimere aromatischer Diisocyanate mit Hydroxyethylacrylat, Hydroxypropylacrylat, 4-Hydroxybutylacrylat eingesetzt werden.

4. Polyurethanzusammensetzungen gemäß einem der Ansprüche 1 bis 2, **dadurch gekennzeichnet, dass**
15 bis 30 Gew.-% der Komponenten A)
30 bis 56.96 Gew.-% der Komponente B),
20 bis 35 Gew.-% der Komponente C)
0.01 bis 0.5 Gew.-% Radikalstabilisatoren D)
1 bis 3 Gew.-% Photoinitiatoren E1)
jeweils 0.01 bis 0.2 Gew.-% der drei Farbstoffe E2), die im Absorptionsspektrum auf die Laserwellenlängen rot, grün und blau abgestimmt sind
0 bis 1 Gew.-% Katalysatoren F)
7 bis 20 Gew.-% Hilfs- und Zusatzstoffe G).

5. Verfahren zum Bedrucken eines Substrats, bei dem Polyurethanzusammensetzungen gemäß einem der Ansprüche 1 bis 4 als Bestandteil der Druckfarbe auf eine Trägerschicht (I) appliziert werden.

6. Verfahren gemäß Anspruch 5, **dadurch gekennzeichnet, dass** die Trägerschicht (I) auf Polycarbonat (PC), Polyethylenterephthalat (PET), Polybutylenterephthalat, Polyethylen, Polypropylen, Celluloseacetat, Cellulosehydrat, Cellulosenitrat, Cycloolefinpolymere, Polystyrol, Polyepoxide, Polysulfon, Cellulosetriacetat (CTA), Polyamid, Polymethylmethacrylat, Polyvinylchlorid, Polyvinylbutyral, Polydicyclopentadien oder deren Mischungen gegebenenfalls auch in Form von Folienlaminaten oder Coextrudaten basiert.

**7.** Verfahren gemäß Anspruch 5 oder 6, **dadurch gekennzeichnet, dass** die durch Drucken aufgebrachten Photopolymerlage (II) eine Gesamtschichtdicke von 3 bis 100 $\mu$m aufweist.

**8.** Verfahren gemäß einem der Ansprüche 5 bis 7, **dadurch gekennzeichnet, dass** anschließend an den Druckvorgang eine Abdeckschicht (III) auf die Photopolymerlage (II) aufgebracht wird.

**9.** Verfahren gemäß einem der Ansprüche 5 bis 8, **dadurch gekennzeichnet, dass** das Material der Abdeckschicht (III) gleich dem der Trägerschicht (I) ist.

**10.** Bedruckter Artikel erhältlich nach einem Verfahren gemäß einem der Ansprüche 5 bis 9.

**11.** Verwendung bedruckter Artikel gemäß Anspruch 10 zur Aufzeichnung visueller Hologramme.

**12.** Verwendung bedruckter Artikel gemäß Anspruch 10 zur Herstellung von optischen Elementen, Bildern, Darstellungen.

**13.** Verfahren zur Aufzeichnung von Hologrammen unter Verwendung der Polyurethanzusammensetzungen gemäß einem der Ansprüche 1-4 und den daraus zugänglichen Medien oder holographischen Filmen.

**Claims**

**1.** Polyurethane compositions suitable for printing, comprising

A) a polyisocyanate component, at least containing an NCO-terminated polyurethane prepolymer whose NCO groups are primarily aliphatically bonded and which is based on hydroxy-functional compounds having an OH functionality of 1.6 to 2.05,
B) isocyanate-reactive polyetherpolyols
C) urethane acrylates and/or urethane methacrylates having at least one aromatic structural unit and a refractive index of greater than 1.50 at 405 nm, which are themselves free of NCO groups and OH groups,
D) free radical stabilizers
E) photoinitiators based on combinations of borate salts and one or more dyes having absorption bands which at least partly cover the spectral range from 400 to 800 nm
F) optionally catalysts
G) auxiliaries and additives,

wherein urethanes or allophanates of aliphatic isocyanate-functional compounds and oligomeric or polymeric isocyanate-reactive compounds are used as prepolymers in A), the prepolymers having number average molar masses of 200 to 10 000 g/mol and NCO functionalities of 1.9 to 5.0.

**2.** Polyurethane compositions according to Claim 1, **characterized in that** difunctional polyetherpolyols based on propylene oxide and ethylene oxide, having a proportion of ethylene oxide of less than 10% by weight, based on the total mass of the parent polyether, and a number average molar mass of 2000 to 4200 g/mol are used in B).

**3.** Polyurethane compositions according to either of Claims 1 and 2, **characterized in that** adducts of aromatic triisocyanates or trimers of aromatic diisocyanates with hydroxyethyl acrylate, hydroxypropyl acrylate, 4-hydroxybutyl acrylate are used as urethane acrylates in C).

**4.** Polyurethane compositions according to either of Claims 1 and 2, **characterized in that**
15 to 30% by weight of the component A)
30 to 56.96% by weight of the component B),
20 to 35% by weight of the component C)
0.01 to 0.5% by weight of free radical stabilizers D)
1 to 3% by weight of photoinitiators E1)

EP 2 396 359 B1

in each case 0.01 to 0.2% by weight of the three dyes E2), which are tailored in the absorption spectrum to the red, green and blue laser wavelengths
0 to 1% by weight of catalysts F)
7 to 20% by weight of auxiliaries and additives G).

5. Process for printing on a substrate, in which polyurethane compositions according to any of Claims 1 to 4 are applied as a constituent of the printing ink to a support layer (I).

6. Process according to Claim 5, **characterized in that** the support layer (I) is based on polycarbonate (PC), polyethylene terephthalate (PET), polybutylene terephthalate, polyethylene, polypropylene, cellulose acetate, cellulose hydrate, cellulose nitrate, cycloolefin polymers, polystyrene, polyepoxides, polysulfone, cellulose triacetate (CTA), polyamide, polymethyl methacrylate, polyvinyl chloride, polyvinyl butyral, polydicyclopentadiene or mixtures thereof, optionally also in the form of film laminates or coextrudates.

7. Process according to Claim 5 or 6, **characterized in that** the photopolymer layer (II) applied by printing has a total layer thickness of 3 to 100 $\mu$m.

8. Process according to any of Claims 5 to 7, **characterized in that** a covering layer (III) is applied to the photopolymer layer (II) after the printing process.

9. Process according to any of Claims 5 to 8, **characterized in that** the material of the covering layer (III) is the same as that of the support layer (I).

10. Imprinted article obtainable by a process according to any of Claims 5 to 9.

11. Use of imprinted articles according to Claim 10 for recording visual holograms.

12. Use of imprinted articles according to Claim 10 for the production of optical elements, images, displays.

13. Method for recording holograms using the polyurethane compositions according to any of Claims 1-4, and the media or holographic films obtainable therefrom.

**Revendications**

1. Compositions de polyuréthane appropriées pour l'impression, comprenant :

    A) un composant polyisocyanate, contenant au moins un prépolymère de polyuréthane à terminaison NCO dont les groupes NCO sont reliés sous forme aliphatique primaire et qui sont à base de composés à fonction hydroxy ayant une fonctionnalité OH de 1,6 à 2,05,
    B) des polyéther-polyols réactifs avec les isocyanates,
    C) des acrylates d'uréthane et/ou des méthacrylates d'uréthane contenant au moins une unité structurale aromatique et ayant un indice de réfraction de plus de 1,50 à 405 nm, qui sont eux-mêmes exempts de groupes NCO et de groupes OH,
    D) des stabilisateurs de radicaux,
    E) des photoinitiateurs à base de combinaisons de sels de borate et d'un ou de plusieurs colorants ayant des bandes d'absorption qui couvrent au moins en partie la plage spectrale de 400 à 800 nm,
    F) éventuellement des catalyseurs,
    G) des adjuvants et des additifs,

    des uréthanes ou des allophanates de composés aliphatiques à fonction isocyanate et de composés oligomères ou polymères réactifs avec les isocyanates étant utilisés en tant que prépolymères en A), les prépolymères présentant des masses molaires moyennes en nombre de 200 à 10 000 g/mol et des fonctionnalités NCO de 1,9 à 5,0.

2. Compositions de polyuréthane selon la revendication 1, **caractérisées en ce que** des polyéther-polyols bifonctionnels à base d'oxyde de propylène et d'oxyde d'éthylène ayant une proportion d'oxyde d'éthylène de moins de 10 pour cent en poids par rapport à la masse totale du polyéther sous-jacent et une masse molaire moyenne en nombre de 2 000 à 4 200 g/mole sont utilisés en B).

**3.** Compositions de polyuréthane selon l'une quelconque des revendications 1 à 2, **caractérisées en ce que** des produits d'addition de triisocyanates aromatiques ou de trimères de diisocyanates aromatiques avec de l'acrylate d'hydroxyéthyle, de l'acrylate d'hydroxypropyle, de l'acrylate de 4-hydroxybutyle sont utilisés en C) en tant qu'acrylates d'uréthane.

**4.** Compositions de polyuréthane selon l'une quelconque des revendications 1 à 2, **caractérisées en ce que**
15 à 30 % en poids du composant A),
30 à 56,96 % en poids du composant B),
20 à 35 % en poids du composant C),
0,01 à 0,5 % en poids de stabilisateurs de radicaux D), 1 à 3 % en poids de photoinitiateurs E1),
à chaque fois 0,01 à 0,2 % en poids des trois colorants E2), qui correspondent sur le spectre d'absorption aux longueurs d'onde laser rouge, verte et bleue,
0 à 1 % en poids de catalyseurs F),
7 à 20 % en poids d'adjuvants et d'additifs G).

**5.** Procédé d'impression d'un substrat, selon lequel des compositions de polyuréthane selon l'une quelconque des revendications 1 à 4 sont appliquées en tant que constituant de l'encre d'impression sur une couche support (I).

**6.** Procédé selon la revendication 5, **caractérisé en ce que** la couche support (I) est à base de polycarbonate (PC), de polyéthylène téréphtalate (PET), de polybutylène téréphtalate, de polyéthylène, de polypropylène, d'acétate de cellulose, d'hydrate de cellulose, de nitrate de cellulose, de polymères de cyclooléfine, de polystyrène, de polyépoxydes, de polysulfone, de triacétate de cellulose (CTA), de polyamide, de polyméthacrylate de méthyle, de polychlorure de vinyle, de polyvinylbutyral, de polydicyclopentadiène ou leurs mélanges, éventuellement également sous la forme de films stratifiés ou de co-extrudats.

**7.** Procédé selon la revendication 5 ou 6, **caractérisé en ce que** la couche de photopolymère (II) appliquée par impression présente une épaisseur de couche totale de 3 à 100 $\mu$m.

**8.** Procédé selon l'une quelconque des revendications 5 à 7, **caractérisé en ce qu'**une couche de recouvrement (III) est appliquée sur la couche de photopolymère (II) après le processus d'impression.

**9.** Procédé selon l'une quelconque des revendications 5 à 8, **caractérisé en ce que** le matériau de la couche de recouvrement (III) est identique à celui de la couche support (I).

**10.** Article imprimé pouvant être obtenu par un procédé selon l'une quelconque des revendications 5 à 9.

**11.** Utilisation d'articles imprimés selon la revendication 10 pour l'enregistrement d'hologrammes visuels.

**12.** Utilisation d'articles imprimés selon la revendication 10 pour la fabrication d'éléments optiques, d'écrans, de présentations.

**13.** Procédé d'enregistrement d'hologrammes utilisant les compositions de polyuréthane selon l'une quelconque des revendications 1 à 4 et les supports ou films holographiques pouvant être obtenus à partir de celles-ci.

**Figur 1:**

Figur 1: Geometrie eines Holographic Media Testers bei λ = 633 nm (He-Ne Laser)zum Schreiben eines Reflexionshologrammes: M = Spiegel, S = Verschluss, SF = Raumfilter, CL = Kollimatorlinse, λ/2 = λ/2 Platte, PBS = polarisationsempfindlicher Strahlteiler, D = Detektor, I = Irisblende, α = 21.8° und β = 41.8° sind die Einfallswinkel der kohärenten Strahlen ausserhalb der Probe (des Mediums) gemessen.

**Figur 2:**

Figur 2: Darstellung der Braggkurve η nach Kogelnik (gestrichelte Linie), des gemessenen Beu-gungswirkungsgrades (ausgefüllte Kreise) und der transmittierten Leistung (schwarz durchgezoge-ne Linie) gegen das Winkeldetuning ΔΩ. Da wegen geometrischem Schrumpf und der Änderung des mittleren Brechungsindexes bei der Photopolymerisation der Winkel bei dem DE gemessen wird von α abweicht wird die x-Achse um diesen Shift zentriert. Der Shift beträgt typischerweise 0° bis 2°.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4959284 A
- EP 352774 A1
- US 020070077498 A
- US 6103454 A
- DE 102004030019
- WO 2005124456 A
- WO 2008125199 A
- WO 03014178 A
- WO 03023520 A
- EP 1002817 A
- EP 2008002464 W
- EP 08017279 A
- EP 08017277 A
- EP 08017273 A
- EP 08017275 A
- EP 0223587 A

**In der Beschreibung aufgeführte Nicht-Patentliteratur**

- **O'NEILL et al.** *Applied Optics,* 2002, vol. 41 (5), 845ff
- **LUO et al.** *Optics Express,* 2005, vol. 13 (8), 3123
- *Springer Series in Optical Sciences,* 2000, vol. 76, 209-228
- XIV/1. Methoden der organischen Chemie. Georg Thieme Verlag, 1961, 433ff
- **CUNNINGHAM et al.** *RadTech'98 North America UV/EB Conference Proceedings,* 19. April 1998
- **H. KOGELNIK.** *The Bell System Technical Journal,* November 1969, vol. 48 (9), 2909, , 2947